(19) Europäisches Patentamt
European Patent Office
Office européen des brevets

(11) Publication number: **0 634 498 A1**

## (12) EUROPEAN PATENT APPLICATION

(21) Application number: **94110182.6**

(22) Date of filing: **30.06.94**

(51) Int. Cl.6: **C23C 14/34**

(30) Priority: **16.07.93 US 92730**

(43) Date of publication of application:
**18.01.95 Bulletin 95/03**

(84) Designated Contracting States:
**BE CH DE ES FR GB IT LI NL SE**

(71) Applicant: **APPLIED MATERIALS, INC.**
**P.O. Box 58039**
**3050 Bowers Avenue**
**Santa Clara**
**California 95052-8039 (US)**

(72) Inventor: **Mintz, Donald M.**
**1633 South Mary Avenue**
**Sunnyvale, CA 94087 (US)**

(74) Representative: **Kahler, Kurt, Dipl.-Ing.**
**Patentanwälte Kahler, Käck, Fiener & Sturm**
**P.O. Box 12 49**
**D-87712 Mindelheim (DE)**

(54) **Etched sputtering target and process.**

(57) A sputtering target (20) having plastically deformed grains (22) is etched with a wet chemical etchant to remove at least a portion of the plastically deformed grains (22) from the surface of the target (20). After etching, the target (20) is mounted in a sputtering zone, and material is sputtered from the target (20) onto a substrate.

Fig. 1a

## BACKGROUND

The present invention relates to sputtering processes and sputtering targets.

Conductive metal films, such as aluminum films are used to interconnect devices in VLSI (very large scale integration) circuits. One method of depositing conductive films onto substrates is by sputtering, also known as physical vapor deposition (PVD).

In sputtering processes, a sputtering target is bombarded by energetic ions, such as a plasma, causing material to be knocked off the target and deposited as a film on the substrate. The crystallographic orientation of the grains in the target affects the distribution of material ejected from the target. Thus, the sputtering target must have a uniform crystalline structure for the sputtering process to produce a uniform and homogeneous film.

Typically, the sputtering targets are disc shaped, being mechanically machined to size using processes such as lathing or milling. These machining processes produce shearing forces on the surface of the target. With reference to Figure 1a, the shearing forces on the target 20 plastically deform the grains 22 on the surface of the target 20 to produce a "smeared" surface grain structure 24. By "plastic deformation" it is meant that adjacent planes of atoms within the grains 22 slip over one another resulting in a permanent lateral displacement of the atomic planes relative to one another, as described in Van Vlack, Elements of Materials Science, 2d Ed., Addison-Wesley Publ. Co. (1964), pages 142-160.

The plastically deformed grains on the target can cause unstable deposition conditions. The smeared grain structure causes the sputtering rate and the properties of the sputtered film to vary with sputtering time. This results in deposition of films with non-uniform thicknesses and properties. In order to obtain stable sputtering conditions and uniform films, it is necessary to remove the plastically deformed grains on the target.

A known method of removing the plastically deformed grains comprises an in situ sputter etching process. In this process, the target is mounted in a sputtering chamber, process gas is introduced into the chamber, and a plasma is generated to etch the target until the plastically deformed grains on the target are removed. Removal of the deformed grains is detected by sputtering films onto test wafers and by examining the deposited films to determine their uniformity. Generally, at least about 100 test wafers must be processed to remove a sufficient thickness of the target.

The in situ sputter etching process is costly, time consuming and inefficient. Typically, the in situ process ties up the sputtering equipment for at least about 4 hours, during which time the sputtering equipment cannot be used for processing wafers. This results in ineffective utilization of expensive sputtering equipment, thereby increasing the cost of processing the substrates.

In situ etching also causes non-uniform etching of the target. Circular annular tracks having widths of about 1 to 3 inches (2.54 to 7.62 cms) form on the target surface because of preferential etching of the target material. Also, the target has central and outer annular regions which are not etched, resulting in only about 50% of the entire surface of the target being actually etched. Thus, the present in situ etch process results in a target that is non-uniformly etched.

Thus, the present process for removing the layer of plastically deformed grains on the sputtering targets is inefficient and costly. Integrated circuit manufacturers require rapid and economical sputtering processes that provide high tolerances on the uniformity, purity, and microstructure of the deposited films. Improvements in film uniformity and deposition rate translate into lower manufacturing cost through higher productivity and device yield. Thus, there is a need for a more efficient sputtering process that can provide a uniform sputtered film.

## SUMMARY

The present invention satisfies these needs. The present invention comprises a method for sputtering comprising the steps of:

(a) selecting a sputtering target having plastically deformed grains;

(b) etching the target with a wet chemical etchant to remove at least a portion of the plastically deformed grains from the target;

(c) after etching the target, mounting the etched target in a sputtering zone;

(d) placing a substrate proximate to the target in the sputtering zone; and

(e) sputtering material from the etched target onto the substrate.

The sputtering target can be made from any metal, such as aluminum, titanium, titanium-tungsten and other metallic alloys, and is preferably disc shaped with a diameter from about 6 to about 24 inches (5.24 to 60.96 cm), and a thickness from about 0.1 to about 1 inches (0.254 to 2.54 cm).

Wet chemical etchants that can be used to etch the target include nitric acid, hydrofluoric acid, hydrochloric acid, sulfuric acid, acetic acid, phosphoric acid, fluoro-boric acid, and mixtures thereof. The concentration of the acid etchant is preferably from about 1% to about 80% by volume. The target can be etched by acid etching or by electropolishing, i.e., by immersing the target in an electropolishing bath containing the etchant and passing a current through the bath.

The wet chemical etched sputtering target is uniformly etched and substantially absent plastically deformed grains over an area comprising at least about 75% of the sputtering surface of the target. Preferably, substantially all of the sputtering surface of the target is uniformly etched.

DRAWINGS

These and other features, aspects, and advantages of the present invention will become better understood from the following drawings, description, and appended claims, where:

Figure 1a is a schematic view in vertical cross section, of a prior art sputtering target having plastically deformed grains on its surface; and

Figure 1b is a schematic view in vertical cross section of the substrate of Figure 1a, after at least a portion of the plastically deformed grains are etched.

DESCRIPTION

The process of the present invention generally comprises selecting a sputtering target having plastically deformed grains, and etching the target by removing at least a portion of the deformed grains from the target. The etched target is then mounted in a sputtering zone; a substrate is placed proximate to the target; and material sputtered from the etched target onto the substrate.

The sputtering target is made from a material that is sought to be deposited on the substrate. For example, in semiconductor processing, the sputtering target is typically a metal or alloy, such as aluminum, titanium, or titanium-tungsten. Alloys can also be sputter deposited using multiple targets, each target made from a different constituent of the alloy.

Typically, the target is disc shaped having a diameter from about 6 to about 24 inches (15.24 to 60.96 cm), and a thickness from about 0.1 to about 1 inch (0.254 to 2.54 cm). More typically, the diameter of the target is from about 10 to about 14 inches (25.4 to 35.56 cm), and its thickness is from about 0.25 to about 0.5 inches (0.635 to 1.27 cm). However, the sputtering target of the present invention is not limited to a particular geometrical configuration, and can be of other conventional sputter target shapes.

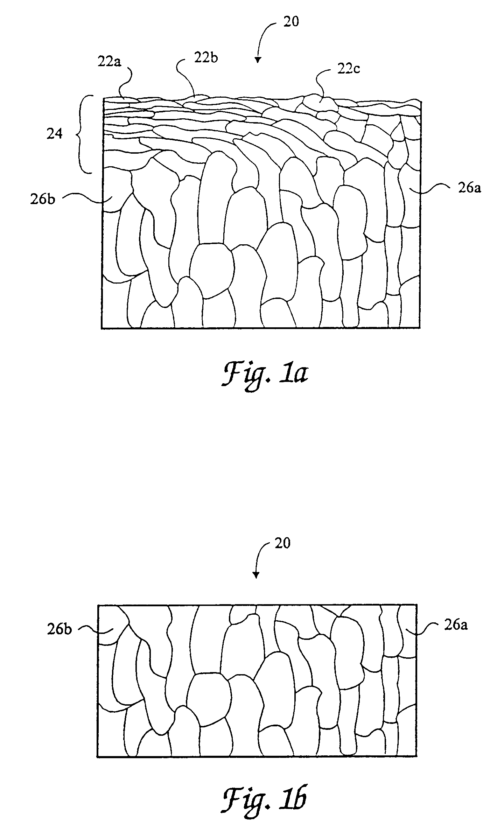

At least a portion of the deformed grains on the target are etched, before the target is mounted in a sputtering apparatus. With reference to Figure 1a, a newly machined target 20 has plastically deformed grains 22 on its surface, the deformed grains forming a "smeared" surface grain structure 24. Under the smeared grain structure 22 remain the undeformed grains 26. The layer of plastically deformed grains 22 on the surface of the target 20 is typically at least about 1 mil (0.00254 cm) thick, and more typically from about 2 to about 6 mils (0.00508 to 0.01524 cm) thick.

With reference to Figure 1b, a uniform target is produced by etching the surface of the target 20 until the smeared grain structure 24 is substantially removed and at least a portion of the underlying undeformed grains 26 are exposed.

The sputtering target is etched with a wet chemical etchant, such as by acid etching or by electropolishing. One method of etching the target comprises immersing or swabbing the target with an acid etchant, such as nitric acid, hydrofluoric acid, hydrochloric acid, sulfuric acid, acetic acid, phosphoric acid, fluoro-boric acid, or mixtures thereof.

Preferably, the wet chemical etchant is mixed with water to dilute the etchant in order to obtain a controlled and uniform etch. Preferably, the strength of the acid is from about 1% to about 80% by volume, and more preferably from about 20% to about 60% by volume.

Table I below provides exemplary etchant solutions that are suitable for etching the sputtering targets of the present invention. A more detailed listing is provided in Metals Handbook, Desk Edition, Ed. by H.E. Boyer and T.L. Gall, Amer. Soc. for Metals (1985) pp.35-51 to 35-52, which are incorporated herein by this reference.

An alternate method of etching the target comprises electropolishing, which is preferred because it provides a smoother surface finish to the target. In this method, the target is immersed in an electropolishing bath containing the wet chemical etchant. The sputtering target forms the anode in the bath and the cathode is a conductive material such as carbon, steel, aluminum or lead. When an electric potential or current is passed through the bath, the surface of the target

## TABLE I

| Etchant Solution | Etching Procedure | Used for Targets Containing: |
|---|---|---|
| Tucker's Reagent: 45 parts conc. HCl, 15 parts $HNO_3$, 15 parts (48%) HF and 25 parts water | Mix fresh; Immerse target; rinse in warm water. | Al; Al-Mn; Al-Si; Al-Mg; Al-Mg-Si |
| 1 part (48%) HF, 9 parts water | Immerse; hot water rinse; dry | Al-Si |
| Poulton's Reagent: 12 parts conc. HCl, 6 parts $HNO_3$, 1 part (48%) HF, 1 part water | Do not heat etchant; Etch by brief immersion or swabbing; rinse in cool water. | Al; Cu; Al-Mn; Al-Si; Al-Mg; Al-Mg-Si |
| 1 ml (48%) HF, 200 ml. water | Swab or immerse. | Fe |
| Keller's reagent: 2 ml (48%) HF, 3 ml conc. HCl, 5 ml conc. $HNO_3$, 190 ml water | Immerse; wash in warm water; blow dry. | Al-Cu; Al-Zn |
| 2 ml (48%) HF, 3 ml conc. HCl, 20 ml conc. $HNO_3$, 175 ml water | Immerse; wash in warm water; blow dry. | Al |
| 25 ml conc. $HNO_3$, 75 ml water | Heat etchant to about 70°C; Immerse. | Fe |
| 20 ml conc. $H_2SO_4$, 80 ml water | Heat etchant to about 70°C; Immerse; rinse in cold water. | Al |
| 10 ml (85%) $H_3PO_4$, 90 ml water | Heat etchant to about 50°C; Immerse. | Al; Al-Zn; Al-Mg |
| 5 ml (48%) HF, 10 ml $H_2SO_4$, 85 ml water | Immerse. | Al |
| 8 ml conc. $HNO_3$, 2 ml conc. HCl, 45 ml methanol, 45 ml water | Immerse. | Al |
| 5 ml glacial acetic acid, 1 ml conc. $HNO_3$, 94 ml water | Immerse. | Al |

anode "dissolves" into the solution, thereby removing at least some of the plastically deformed grains on the surface of the target.

The etchant in the electropolishing bath is typically a polishing acid such as hydrofluoric acid, nitric acid, sulfuric acid, fluoro-boric acid, or mixtures thereof. For example, the electroplating bath can comprise Barker's Reagent, which is about 2-2.5% by volume of 48% conc. fluoro-boric acid ($HBF_4$) in water. The

4

target is electropolished by passing a current with potential of about 20 Volts DC and a current density of about 0.2 Amps/cm$^2$, through the bath, as described in Metals Handbook, Desk Edition, Ed. by H.E. Boyer and T.L. Gall, Amer. Soc. for Metals (1985) pp.35-51 to 35-52.

The wet chemical etching processes uniformly etches at least about 75% of the surface of the target and preferably etches substantially the entire sputtering surface of the target. By "uniformly" etched it is meant that the target is etched smoothly, without circular annular rings across the sputtering surface of the target. The uniformly etched region is substantially absent plastically deformed grains.

After the target is etched, it is mounted in the sputtering zone of a sputtering apparatus, such as an "ENDURA 5500" brand sputtering apparatus available from Applied Materials, Inc., Santa Clara, California.

A substrate is placed proximate to the target. The substrate can be anything on which a sputtered film is to be deposited, including silicon or gallium arsenide wafers, glass, or metal substrates. Typically, the substrate is a silicon wafer having multiple layers thereon, such as metal, oxide, silicide, nitride, and boride layers.

In the sputtering process, a process gas is introduced into the sputtering zone of the sputtering apparatus. The process gas can be an inert gas, such as argon or helium, or a reactive gas such as nitrogen, ammonia, methane, or diborane. The chamber is generally maintained at a pressure ranging from about 0.133 Pa to about 66.66 Pa (1 mTorr to about 500 mTorr), and a plasma is generated in the sputtering zone by generating a potential drop between the sputtering target and grounded portions of the sputtering chamber. The plasma can be enhanced by electron cyclotron resonance, magnetically enhanced, or enhanced by inductive coupling.

Any sputtering process can be used with the sputtering target of the present invention. Exemplary sputtering process are described in U.S. Patent No. 3,616,402 to Kumagai, entitled "Sputtering Method and Apparatus"; U.S. Patent No. 3,617,463 to Gregor at. al., entitled "Apparatus and Method for Sputter Etching"; U.S. Patent No. 4,450,062 to Macaulay et. al., entitled "Sputtering Apparatus and Method"; U.S. Patent No. 5,209,835 to Makino et. al., entitled "Method for Producing a Specified Zirconium-Silicon Amorphous Oxide Film Composition by Sputtering"; U.S. Patent No. 5,175,608 to Nihei et. al. entitled "Method of and Apparatus for Sputtering and Integrated Circuit Device"; and U.S. Patent No. 5,160,534 to Hiraki et. al. entitled "Titanium-Tungsten Target Material for Sputtering and Manufacturing Method Therefor", all of which are incorporated herein by this reference.

EXAMPLE

A one square inch segment of the machined surface of an aluminum sputtering target was electropolished by immersing the target segment in an electropolishing bath comprising about 2% by volume of 48% conc. HBF$_4$ in water. A current of about 0.5 amps was passed through the solution for about 30 minutes, until approximately 4 mils (0.1 mm) of the surface of the target segment was removed.

The surfaces of the un-etched and post-etched target segment were examined using the (200) and (220) pole figures generated by x-ray diffraction techniques as described in Mark B. Dittmar, "The Role of X-Ray Diffraction in the Control of Sputtering Target Crystal Texture," TOSOH SMD, Inc., Technical Note of Specialty Metals Division, Grove City, Ohio (1986). It was determined the surface of the target segment after the wet chemical etch, was substantially absent plastically deformed grains.

PROSPECTIVE EXAMPLE

In order to etch the entire surface of a sputtering target using the solution of Example 1, the amount of current passed through the solution is proportionately increased. To etch a target having a diameter of about 12 inches (30.48 cm) and a thickness of about 0.46 inches (1.17 cm), a current of about 150 amps is passed through the solution. The area of such a target is approximately 730 cm$^2$; therefore, a current density of about 0.2 amp/cm$^2$ is obtained.

The present invention provides an efficient sputtering process which does not tie up use of the sputtering equipment or require the use of test wafers or analysis time, and which provides deposition of a uniform film. A sputtering target prepared according to the present invention is uniformly etched and substantially absent plastically deformed grains.

Although the present invention has been described in considerable detail with regard to the preferred version thereof, other versions are possible.

EP 0 634 498 A1

**Claims**

1. A method for sputtering comprising the steps of:
   (a) selecting a sputtering target having plastically deformed grains;
   (b) etching the target with a wet chemical etchant to remove at least a portion of the plastically deformed grains from the target;
   (c) after etching the target, mounting the etched target in a sputtering zone;
   (d) placing a substrate proximate to the target in the sputtering zone; and
   (e) sputtering material from the etched target onto the substrate.

2. The method of claim 1,
   wherein the step of selecting a target comprises selecting a target made of a material selected from the group consisting of aluminum, titanium, and titanium-tungsten.

3. The method of claim 1 or 2,
   wherein the step of selecting a target comprises selecting a disc shaped target having a diameter from about 5.24 to about 60.96 cm (6 to about 24 inches), and a thickness from about 0.254 to about 2.54 cm (0.1 to about 1 inches).

4. The method of any of claims 1 to 3,
   wherein the wet chemical etchant is an acid.

5. The method of claim 4,
   wherein the wet chemical etchant is selected from the group consisting of nitric acid, hydrofluoric acid, hydrochloric acid, sulfuric acid, acetic acid, phosphoric acid, fluoro-boric acid, and mixtures thereof.

6. The method of claim 4 or 5,
   wherein the concentration of the acid is from about l% to about 80% by volume.

7. The method of claim 6,
   wherein the concentration of the acid is from about 20% to about 60% by volume.

8. The method of any of claims 1 to 7,
   wherein the step of etching the target comprises:
   (a) placing the sputtering target in an electropolishing bath containing the wet chemical etchant; and
   (b) applying an electrical current to the electropolishing bath.

9. The method of claim 8,
   wherein the electropolishing bath comprises fluoro-boric acid.

10. The method of claim 9,
    wherein the concentration of the acid is from about l% to about 10% by volume.

11. The method of any of claims 1 to 10,
    wherein the step of sputtering material from the etched target onto the substrate comprises:
    (a) introducing a process gas into the sputtering zone; and
    (b) generating a plasma in the sputtering zone so that the process gas forms a sputtering gas which removes material from the etched target for deposition onto the substrate.

12. A method for preparing a uniformly etched sputtering target comprising the steps of:
    (a) selecting a sputtering target; and
    (b) etching the target with a wet chemical etchant to remove at least a portion of the plastically deformed grains on the sputtering target.

13. The method of claim 12,
    wherein the sputtering target has plastically deformed grains.

6

**14.** The method of claim 12,
wherein the wet chemical etchant is an acid.

**15.** The method of claim 14,
wherein the wet chemical etchant is selected from the group consisting of nitric acid, hydrofluoric acid, hydrochloric acid, sulfuric acid, acetic acid, phosphoric acid, fluoro-boric acid and mixtures thereof.

**16.** The method of claim 15,
wherein the concentration of the acid is from about l% to about 80% by volume.

**17.** The method of claim 16,
wherein the concentration of the acid is from about 20% to about 60% by volume.

**18.** The method of any of claims 12 to 17,
wherein the step of etching the sputtering target comprises the steps of:
   (c) placing the sputtering target in an electropolishing bath containing the wet chemical etchant; and
   (d) applying an electrical current to the electropolishing bath.

**19.** The method of claim 18,
wherein the electropolishing bath comprises fluoro-boric acid.

**20.** The method of claim 19,
wherein the concentration of the acid is from about l% to about 10% by volume.

**21.** The sputtering target prepared by the method of claim 12.

**22.** A sputtering apparatus comprising the etched sputtering target of claim 21.

**23.** A sputtering target comprising a disc having a diameter from about 5.24 to about 60.96 cm (6 to about 24 inches), and a thickness from about 0.254 to about 2.54 cm (0.1 to about 1 inch), the target having a sputtering surface thereon, wherein an area comprising at least about 75% of the sputtering surface of the target is uniformly etched and substantially absent plastically deformed grains.

**24.** The target of claim 23,
wherein substantially all the surface of the target is uniformly etched and substantially absent plastically deformed grains.

**25.** The target of claim 23,
wherein the target is made from a material selected from the group consisting of aluminum, titanium, and titanium-tungsten.

**26.** The target of claim 23,
wherein the diameter of the disc is from about 25.4 to about 35.56 cm (10 to about 14 inches), and the thickness of the disc is from about 0.635 to about 1.27 cm (0.25 to about 0.5 inches).

20

22a 22b 22c

24

26b 26a

Fig. 1a

20

26b 26a

Fig. 1b

## DOCUMENTS CONSIDERED TO BE RELEVANT

EP 94110182.6

| Category | Citation of document with indication, where appropriate, of relevant passages | Relevant to claim | CLASSIFICATION OF THE APPLICATION (Int. Cl. 6) |
|---|---|---|---|
| A | DERWENT ACCESSION no. 90-212 546, Questel Telesystems (WPIL) DERWENT PUBLICATIONS LTD., London; & JP-A-02 141 571 ((TOKE) TOSHIBA K.K.) * Abstract * | 1-26 | C 23 C 14/34 |
| A | DERWENT ACCESSION no. 90-358 425, Questel Telesystems (WPIL) DERWENT PUBLICATIONS LTD., London; & JP-A-02 259 068 ((SHIH) EPSON CORP.) * Abstract * | 1-26 | |
| A | DD - A - 252 005 (FORSCHUNGSINSTITUT MANFRED VON ARENNE) * Abstract; claim * | 1-26 | |

TECHNICAL FIELDS SEARCHED (Int. Cl.6)

C 23 C

The present search report has been drawn up for all claims

| Place of search | Date of completion of the search | Examiner |
|---|---|---|
| VIENNA | 14-10-1994 | HAUK |

EPO FORM 1503 03.82 (P0401)